# EUROPÄISCHE PATENTSCHRIFT

(11) **EP 0 716 310 B1**
(45) Veröffentlichungstag und Bekanntmachung des Hinweises auf die Patenterteilung: **02.05.2002**
(21) Anmeldenummer: 95118735.0
(22) Anmeldetag: 29.11.1995
(51) Int. Cl.: G01R 31/00, B60R 16/02

(54) **Schaltungsanordnung zur Ansteuerung und Überwachung elektrischer Lasten in einem Kraftfahrzeug**
Circuit for driving and monitoring electric loads in a motor vehicle
Circuit de commande et de surveillance de charges électriques dans un véhicule à moteur

(30) Priorität: 06.12.1994 DE 4443350
(43) Veröffentlichungstag der Anmeldung: 12.06.1996
(73) Patentinhaber: Hella KG Hueck & Co., 59552 Lippstadt (DE)
(72) Erfinder: Trinschek, Martin, D-59069 Hamm (DE)

(56) Entgegenhaltungen:
- EP-A- 0 458 300
- WO-A-87/07388
- WO-A-92/08141
- DE-C- 3 706 786

## Beschreibung

Die Erfindung betrifft eine Schaltungsanordnung zur Ansteuerung und Überwachung elektrischer Lasten in einem Kraftfahrzeug mit elektrischen Lasten, die über steuerbare Lastschalter an eine Spannung anschaltbar sind, und einer Ablaufsteuerungseinrichtung, die die steuerbaren Lastschalter ansteuert und die von jeder Last ein Spannungssignal abgreift.

Das Dokument EP-A-0 458 300 offenbart eine solche Schaltungs anordnung.

Solche Schaltungsanordnungen zur Überwachung elektrischer Lasten besitzen üblicherweise einen Meßwiderstand, der mit der elektrischen Last in Reihe geschaltet ist, wobei zur Überwachung der Last der Spannungsabfall an dem Meßwiderstand ausgewertet wird.

Hierbei ist nachteilig, daß besonders bei sehr niederohmigen elektrischen Lasten der Meßwiderstand ebenfalls sehr niederohmig ausgeführt sein muß, um die Funktion der elektrischen Last nicht zu beeinträchtigen.

Solche niederohmige Meßwiderstände sind aber nur auf aufwendige Weise zu fertigen und besitzen relativ große Abmessungen. Nachteilig ist auch, daß zur Auswertung der sehr geringen Spannungen, die an niederohmigen Meßwiderständen abfallen, ein erheblicher Schaltungsaufwand erforderlich ist. Diese Auswerteschaltungen sind zudem besonders gegenüber elektromagnetischen Störeinflüssen empfindlich.

Es soll daher eine Schaltungsanordnung geschaffen werden, bei der zur Prüfung kein Reihenwiderstand im Lastkreis benötigt wird.

Aus der DE 35 33 523 C2 ist eine Schaltungsanordnung bekannt, bei der kein Reihenwiderstand zwischen Lastschalter und Last vorgesehen ist. Die Schaltungsanordnung weist zur Lastüberwachung einen Komparator auf, der den Spannungsabfall an elektrischen Lastschaltern mit einer Referenzspannung vergleicht.

Hierbei ist nachteilig, daß eine Überprüfung des Lastkreises nur auf Unterbrechung oder Kurzschluß erfolgt. Quantitative Eigenschaften der Lasten, insbesondere deren Widerstandswerte, können mit dieser Anordnung nicht überwacht werden. Nachteilig bei dieser Schaltungsanordnung ist weiterhin, daß aufgrund des einen verwendeten Komparators die Lasten im wesentlichen gleichartige elektrische Eigenschaften aufweisen müssen.

Es ist daher die Aufgabe der Erfindung, eine einfache und kostengünstige Schaltungsanordnung zu schaffen, die ohne einen Reihenwiderstand im Lastkreis auskommt und trotzdem die Überwachung quantitativer Eigenschaften der Last, und zwar unter Vermeidung der oben genannten Nachteile, ermöglicht.

Diese Aufgabe wird erfindungsgemäß dadurch gelöst, daß die Spannungssignale an genau zwei Lasten überwacht werden oder daß mehrere Lasten jeweils paarweise überwacht werden, daß die spannungsüberwachten Anschlüsse beider Lasten über ein Verknüpfungsnetzwerk elektrisch miteinander verbunden sind und daß zur Überwachung der Spannungssignale eine der Lasten eingeschaltet ist und die jeweils andere Last abgeschaltet ist und daß die am Verbindungspunkt zwischen dem Verknüpfungsnetzwerk und der jeweils anderen Last anliegende Spannung jeweils einem Analog-Digital-Wandler zugeführt wird.

Die erfindungsgemäße Schaltungsanordnung ist in vielerlei Hinsicht vorteilhaft. So werden zur Überwachung der Lasten keine kostenaufwendigen großbauenden niederohmigen Widerstände benötigt, sondern es wird nur ein mindestens einen Widerstand enthaltendes Verknüpfungsnetzwerk vorgesehen.

Da der mindestens eine Widerstand des Verknüpfungsnetzwerks nicht vom vollen Laststrom durchflossen wird, kann dieser verglichen mit den Lastwiderständen relativ hochohmig ausgeführt werden (Prüfwiderstand etwa um Faktor 10x größer als der zugehörige Lastwiderstand).

Da im Fall gleichartiger Lasten das Verknüpfungsnetzwerk aus nicht mehr als einem Widerstand besteht, der zur Überwachung beider Lasten verwendet wird, ist die Schaltungsanordnung ganz besonders einfach und kostengünstig.

Vorteilhaft ist auch, daß der Schaltungsaufwand zur Überwachung der Lasten sehr gering ist, so werden beispielsweise keine Prüfschalter benötigt, um die Lasten an eine Prüfeinrichtung anzuschalten, sondern die Überwachung der Lasten erfolgt während des normalen Betriebes an einer momentan abgeschalteten oder zur Prüfung kurzzeitig abgeschalteten Last.

Vorteilhaft ist auch, da die Überwachung der Lasten durch die Ablaufsteuerungseinrichtung vorgenommen wird, mit einem relativ geringen Aufwand eine quantitative Überwachung des Lastwiderstandes möglich ist.

Weitere vorteilhafte Ausgestaltungen und Weiterbildungen gehen aus den Unteransprüchen hervor.

So ist es für bestimmte Anwendungen vorteilhaft, wenn das Verknüpfungsnetzwerk für verschiedene Stromrichtungen unterschiedliche Ersatzwiderstände aufweist. Hierdurch können die zu überwachenden Lasten sehr verschiedenartige Lastwiderstände aufweisen.

Besonders vorteilhaft ist auch, daß der Mikrocomputer aus den zwei überwachten Spannungssignalen die Innenwiderstände der Lasten berechnen kann. Hierdurch kann neben der üblichen Prüfung auf Kurzschluß oder Unterbrechung des Lastkreises auch eine längerfristige Veränderung der Lastwiderstände festgestellt werden.

Eine besonders vorteilhafte Anwendung dieser erfindungsgemäßen Schaltungsanordnung liegt in der Überwachung von Glühkerzen bzw. von Glühkerzen und Magnetventilen, welche zu dem Verbrennungsmotor eines Kraftfahrzeuges gehören.

Im folgenden soll ein Ausführungsbeispiel der erfindungsgemäßen Schaltungsanordnung anhand der Zeichnung dargestellt und näher erläutert werden.

Es zeigen
- Figur 1: ein Blockschaltbild der erfindungsgemäßen Schaltungsanordnung;
- Figur 2: zwei Beispiele für die Ausbildung des Verknüpfungsnetzwerkes.

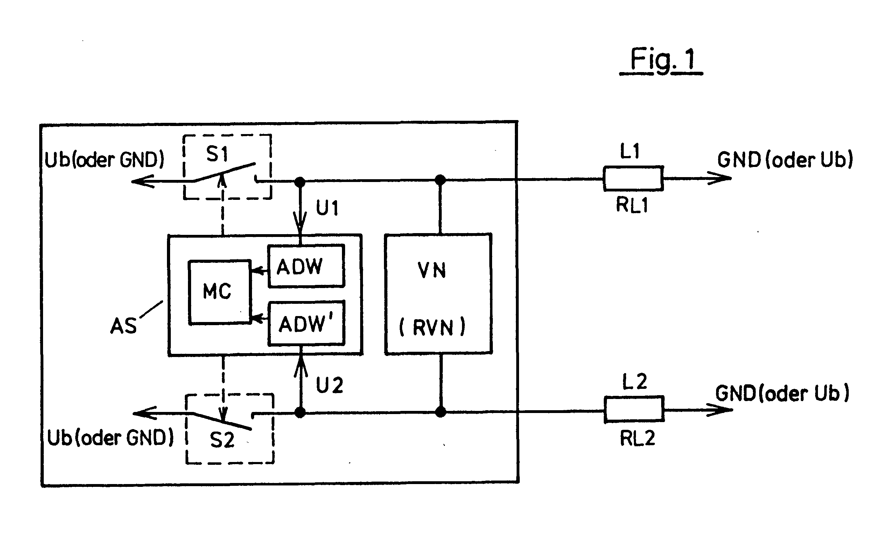

Die Figur 1 zeigt eine Schaltungsanordnung, bei der zwei Lasten (L1, L2) über jeweils einen elektromechanischen (Relais) oder elektronischen (z. B. Leistungs-FET) Lastschalter (S1, S2) an die Betriebsspannung (UB) oder alternativ auch gegen Masse (GND) geschaltet werden.

Die Lastschalter (S1, S2) werden durch die Ablaufsteuerungseinrichtung (AS) angesteuert, wobei die Ablaufsteuerungseinrichtung zur Ausführung von Steuerungsaufgaben einen Mikrocomputer (MC) aufweist.

An den Verbindungspunkten von Lastschaltern (S1, S2) und Lasten (L1, L2) wird jeweils eine Spannung (U1, U2) abgegriffen und der Ablaufsteuerungseinrichtung (AS) zugeführt. Die Ablaufsteuerungseinrichtung (AS) führt die Spannungssignale (U1, U2) über jeweils einen Analog-Digital-Wandler (ADW, ADW') dem Mikrocomputer (MC) zu.

Alternativ (in der Figur 1 nicht dargestellt) kann auch vorgesehen werden, daß die Ablaufsteuerungseinrichtung (AS) nur einen Analog-Digital-Wandler aufweist und das zu prüfende Spannungssignal (U1, U2) von dem Mikrocomputer (MC) abwechselnd auf die Eingänge des Analog-Digital-Wandlers geschaltet werden.

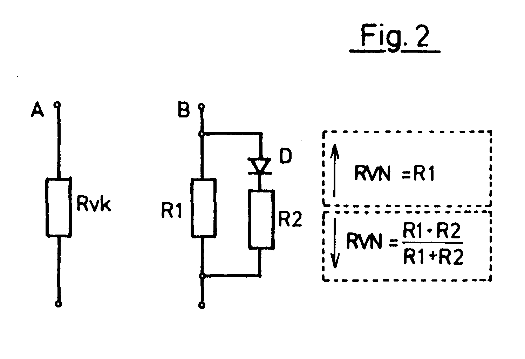

Weiterhin weist die Schaltungsanordnung ein Verknüpfungsnetzwerk (VN) auf, welches im wesentlichen ein Widerstandsnetzwerk darstellt oder im einfachsten Fall aus einem einzelnen Widerstand besteht (zwei noch näher zu erläuternde vorteilhafte Ausführungsformen des Verknüpfungsnetzwerkes zeigt die Figur 2) und das mit den geschalteten Anschlüssen beider Lasten verbunden ist.

Zur Erläuterung der Funktionsweise der erfindungsgemäßen Schaltungsanordnung sei zunächst angenommen, daß die zu schaltenden Lasten (L1, L2) in etwa gleichartige elektrische Eigenschaften, das heißt, insbesondere ähnliche Innenwiderstände (RL1, RL2) aufweisen, und das Verknüpfungsnetzwerk durch einen einfachen Widerstand (siehe Figur 2A) mit dem konstanten Ersatzwiderstandswert (RVN) ausgebildet ist.

Die Lasten (L1, L2) können beispielsweise Glühkerzen in einem selbstzündenden Kraftfahrzeugmotor sein, wobei solche Glühkerzen beispielsweise einen Innenwiderstand von ca. 0,6 Ohm aufweisen.

Es ist daher kaum möglich, in dem Laststromkreis einen Prüfwiderstand mit der Last in Reihe zu schalten, da hierdurch entweder die Funktion der Last beeinträchtigt oder der Prüfwiderstand höchst niederohmig ausgeführt werden müßte, wodurch der Prüfwiderstand ein großes Bauvolumen aufweisen würde. Solche Prüfwiderstände sind zudem als Spezialanfertigungen teuer und schwer zu handhaben.

Zur Bestimmung der Innenwiderstände (RL1, RL2) der Lasten (L1, L2) wird daher folgendermaßen verfahren: Angenommen die Last (L1) sei über den Lastschalter (S1) eingeschaltet; der Lastschalter (S2) sei offen. Dann fließt über den Schalter (S1) und das Verknüpfungsnetzwerk (VN) auch ein Strom durch die Last (L2). Am Verbindungspunkt zwischen Verknüpfungsnetzwerk (VN) und Last (L2) greift die Ablaufsteuerungseinrichtung (AS) die Spannung (U2) ab, die vom Widerstandsverhältnis von Last (RL2) und dem Ersatzwiderstand des Verknüpfungsnetzwerkes (RVN) abhängt.

Vorteilhafterweise braucht der Ersatzwiderstand (RVN) des Verknüpfungsnetzwerkes (VN) nicht kleiner zu sein als der Lastwiderstand (RL2); ja er sollte sogar ein Mehrfaches des Lastwiderstandes (RL2) betragen, da die Last (L2) ja nur zu Prüfzwecken bestromt, aber nicht eingeschaltet werden soll.

Auf vergleichbare Weise (Lastschalter (S2) geschlossen, (S1) offen) kann an der Last (L1) der Spannungswert (U1) bestimmt werden. Sind zum Zeitpunkt des Prüfvorganges beide Lasten (L1, L2) eingeschaltet, wird die zu prüfende Last (L1) für die (sehr kurze) Dauer des Prüfvorganges abgeschaltet, wodurch die Funktion der geprüften Last im allgemeinen nicht beeinträchtigt wird.

Aus den so bestimmten Spannungswerten (U1, U2) kann der Mikrocomputer (MC) unter Verwendung der bekannten Werte für den Ersatzwiderstand (RVN) des Verknüpfungsnetzwerkes (VN) die Innenwiderstände (RL1, RL2) der Lasten (L1, L2) berechnen. Beispielsweise errechnet sich (RL2) über die Beziehung : RL2 = U2 x RVN/(U1 - U2).

Neben der Überwachung von Leistungsunterbrechungen und Kurzschlüssen in den Lastkreisen ist so auch eine quantitative Überprüfung der Lastwiderstände möglich.

Von besonderem Vorteil ist, daß auch Lasten mit gänzlich unterschiedlichen elektrischen Eigenschaften durch die erfindungsgemäße Schaltungsanordnung geprüft werden können.

Als Anwendungsbeispiel soll beispielsweise eine Glühkerze und ein Magnetventil in einem Kraftfahrzeugmotor als anzusteuernde und zu überwachende Lasten (L1, L2) vorgesehen werden. Die Glühkerze besitzt mit ca. 0,6 Ohm einen deutlich kleineren Innenwiderstand als das Magnetventil (ca. 40 Ohm).

Damit das Verknüpfungsnetzwerk (VN) für beide Lasten (L1, L2) einen Prüfwiderstand in der richtigen Größenordnung ausbildet, kann das Verknüpfungsnetzwerk (VN) so ausgebildet werden, daß dessen Ersatzwiderstand (RVN) stromrichtungsabhängig ist.

Eine solche Ausgestaltung des Verknüpfungsnetzwerkes (VN) zeigt die Figur 2B. In Sperrichtung der Diode (D) ist der Ersatzwiderstand (RVN) des Verknüpfungsnetzwerkes (VN) gleich dem Wert des Widerstandes (R1); in Durchlassrichtung der Diode (D) entspricht der Ersatzwiderstand (RVN) des Verknüpfungsnetzwerks (VN) (unter Vernachlässigung des Innenwiderstandes der Diode) dem der parallel geschalteten Widerstände R1 und R2.

Somit ist eine Anpassung des Verknüpfungsnetzwerkes an Lasten mit unterschiedlichen elektrischen Eigenschaften leicht möglich.

### Bezugszeichenliste

Schaltungsanordnung zur Ansteuerung und Überwachung elektrischer Lasten in einem Kraftfahrzeug
- ADW, ADW': Analog-Digital-Wandler
- AS: Ablaufsteuerungseinrichtung
- D: Diode
- L1, L2: (elektrische) Lasten
- MC: Mikrocomputer
- R1, R2: Widerstände
- RL1, RL2: Innenwiderstände der Lasten (L1, L2)
- RVN: Ersatzwiderstand des Verknüpfungsnetzwerkes (VN)
- S1, S2: Lastschalter
- VN: Verknüpfungsnetzwerk
- U1, U2: Spannungssignale bzw. Spannungswerte
- UB: Betriebsspannung
- GND: Masse

## Patentansprüche

1. Schaltungsanordnung zur Ansteuerung und Überwachung elektrischer Lasten in einem Kraftfahrzeug mit elektrischen Lasten (L1, L2), die über steuerbare Lastschalter (S1, S2) an eine Spannung anschaltbar sind, und einer Ablaufsteuerungseinrichtung (AS), die die steuerbaren Lastschalter (S1, S2) ansteuert und die von jeder Last (L1, L2) ein Spannungssignal (U1, U2) abgreift, **dadurch gekennzeichnet, daß** die Spannungssignale (U1, U2) an genau zwei Lasten überwacht werden oder daß mehrere Lasten jeweils paarweise überwacht werden, daß die spannungsüberwachten Anschlüsse beider Lasten (L1, L2) über ein Verknüpfungsnetzwerk (VN) elektrisch miteinander verbunden sind und daß zur Überwachung der Spannungssignale (U2 bzw. U1) eine der Lasten (L1 bzw. L2) eingeschaltet ist und die jeweils andere Last (L2 bzw. L1) abgeschaltet ist und daß die am Verbindungspunkt zwischen dem Verknüpfungsnetzwerk (VN) und der jeweils anderen Last (L2 bzw. L1) anliegende Spannung (U2, U1) jeweils einem Analog-Digital-Wandler (ADW, ADW') zugeführt wird.

2. Schaltungsanordnung nach Anspruch 1, **dadurch gekennzeichnet, daß** nur ein Analog-Digital-Wandler vorgesehen ist und die Ablaufsteuerung bei Ansteuerung eines Lastschalters (S1, S2) das Spannungssignal (U2, U1) der jeweils nicht eingeschalteten Last (L2, L1) auf den Analog-Digital-Wandler schaltet.

3. Schaltungsanordnung nach Anspruch 1 oder 2, **dadurch gekennzeichnet, daß** der oder die Analog-Digital-Wandler (ADW, ADW') ein integrierter Bestandteil der Ablaufsteuerungseinrichtung ist.

4. Schaltungsanordnung nach Anspruch 1, **dadurch gekennzeichnet, daß** das Verknüpfungsnetzwerk (VN) aus mindestens einem Widerstand (R1) besteht.

5. Schaltungsanordnung nach Anspruch 4, **dadurch gekennzeichnet, daß** das Verknüpfungsnetzwerk (VN) zusätzlich mindestens eine Halbleiterdiode (D) aufweist und der Ersatzwiderstand (RVN) des Verknüpfungsnetzwerkes (VN) stromrichtungsabhängig ist.

6. Schaltungsanordnung nach Anspruch 1, **dadurch gekennzeichnet, daß** die Ablaufsteuerungseinrichtung (AS) einen Mikrocomputer (MC) aufweist, der aus den von dem oder den Digitalwandlern (ADW, ADW') digitalisierten Spannungssignalen und dem Ersatzwiderstand (RVN) des Verknüpfungsnetzwerkes (VN) die Innenwiderstände (RL1, RL2) der Lasten (L1, L2) berechnet.

7. Schaltungsanordnung nach Anspruch 5, **dadurch gekennzeichnet, daß** die Widerstandswerte der Lastwiderstände (L1, L2) sich um mindestens eine Größenordnung unterscheiden.

8. Schaltungsanordnung nach Anspruch 7, **dadurch gekennzeichnet, daß** die Lasten (L1, L2) als Glühkerzen und Magnetventile im Verbrennungsmotor eines Kraftfahrzeuges ausgeführt sind.

## Claims

1. Circuit arrangement for triggering and monitoring electrical loads in a motor vehicle, with electrical loads (L1, L2) that are connectable to a voltage by controllable power circuit breakers (S1, S2), and a sequencing control device (AS) which triggers the controllable power circuit breakers (S1, S2) and taps off a voltage signal (U1, U2) from each load (L1, L2), **characterized in that** the voltage signals (U1, U2) are monitored on precisely two loads or **in that** a plurality of loads are monitored in pairs, **in that** the voltage-monitored connections of the two loads (L1, L2) are electrically interconnected via a switching network (VN) and **in that** in order to monitor the voltage signals (U2 or U1) one of the loads (L1 or L2, respectively) is switched on and the other load (L2 or L1, respectively) is switched off and **in that** the individual voltage (U2, U1) present at the connection point between the switching network (VN) and the other load (L2 or L1, respectively) is fed to an analogue-digital converter (ADW, ADW').

2. Circuit arrangement according to Claim 1, **characterized in that** only one analogue-digital converter is provided and the sequencing control upon triggering a power circuit breaker (S1, S2) switches the voltage signal (U2, U1) of that load which is not switched on (L2, L1) to the analogue-digital converter.

3. Circuit arrangement according to Claim 1 or Claim 2, **characterized in that** the analogue-digital converter or converters (ADW, ADW') is [or are] an integral component of the sequencing control device.

4. Circuit arrangement according to Claim 1, **characterized in that** the switching network (VN) consists of at least one resistor (R1).

5. Circuit arrangement according to Claim 4, **characterized in that** the switching network (VN) also has at least one semiconductor diode (D) and the substitutional resistance (RVN) of the switching network (VN) is dependent on current direction.

6. Circuit arrangement according to Claim 1, **characterized in that** the sequencing control device (AS) has a microcomputer (MC) which calculates the internal resistances (RL1, RL2) of the loads (L1, L2) from the voltage signals digitalized by the digital converter or converters (ADW, ADW') and the substitutional resistance (RVN) of the switching network (VN).

7. Circuit arrangement according to Claim 5, **characterized in that** the resistance values of the load resistances (L1, L2) differ by at least one order of magnitude.

8. Circuit arrangement according to Claim 7, **characterized in that** the loads (L1, L2) are configured as heater plugs and solenoid valves in the combustion engine of a motor vehicle.

## Revendications

1. Montage pour la commande et le contrôle de charges électriques dans un véhicule, comportant des charges électriques (L1, L2), qui peuvent être raccordées à une tension par l'intermédiaire d'interrupteurs de charge commandables (S1, S2), et un dispositif de commande d'exécution (AS), qui commande les interrupteurs de charge commandables (S1, S2) et qui prélève de chaque charge (L1, L2) un signal de tension (U1, U2), **caractérisé en ce que** les signaux de tension (U1, U2) sont contrôlés au niveau précisément de deux charges, ou que plusieurs charges sont contrôlées respectivement par paires, que les bornes, contrôlées en tension, des deux charges (L1, L2) sont reliées électriquement entre elles par l'intermédiaire d'un réseau combinatoire (VN), et que pour le contrôle des signaux de tension (U2 ou U1), une des charges (L1 ou L2) est débranchée et que la tension (U2, U1), qui est appliquée au point de jonction entre le réseau combinatoire (VN) et l'autre charge respective (L2 ou L1), est envoyée respectivement à un convertisseur analogique / numérique (ADW, ADW').

2. Montage selon la revendication 1, **caractérisé en ce qu'**un seul convertisseur analogique / numérique est prévu et que lors de la commande d'un interrupteur de charge (S1, S2), l'unité de commande d'exécution commute le signal de tension (U2, U1) de la charge (L2, L1) respectivement non branchée sur le convertisseur analogique / numérique.

3. Montage selon la revendication 1 ou 2, **caractérisé en ce que** le ou les convertisseurs analogique /numérique (ADW, ADW') sont un composant intégré du dispositif de commande d'exécution.

4. Montage selon la revendication 1, **caractérisé en ce que** le réseau combinatoire (VN) est constitué par au moins une résistance (R1).

5. Montage selon la revendication 3, **caractérisé en ce que** le réseau combinatoire (VN) comporte en outre au moins une diode semiconductrice (D) et que la résistance équivalente (AVN) du réseau combinatoire (VN) dépend du sens du courant.

6. Montage selon la revendication 1, **caractérisé en ce que** le dispositif de commande d'exécution (AS) comprend un micro-ordinateur (MC), qui calcule les résistances internes (RL1, RL2) des charges (L1, L2) à partir des signaux de tension, qui sont numérisés par le ou les convertisseurs numériques (ADW, ADW') et à partir de la résistance équivalente (RVN) du réseau combinatoire (VN).

7. Montage selon la revendication 5, **caractérisé en ce que** les valeurs des résistances de charge (L1, L2) diffèrent d'au moins un ordre de grandeur

8. Montage selon la revendication 7, **caractérisé en ce que** les charges (L1, L2) sont agencées sous la forme de bougies d'allumage et de soupapes magnétiques dans le moteur à combustion interne d'un véhicule automobile.
